# EUROPEAN PATENT APPLICATION

(11) **EP 4 845 034 A1**
(43) Date of publication of application: **25.11.2026**
(21) Application number: 26179221.2
(22) Date of filing: 18.05.2026
(51) Int. Cl.: H03L 7/197, H03L 7/08, H04B 1/707

(54) **SPREAD SPECTRUM FRACTIONAL-N CONTROL CIRCUIT, FRACTIONAL-N PLL AND CHIP**

(30) Priority: 19.05.2025 CN 202510645099
(71) Applicant: GIGADEVICE SEMICONDUCTOR INC., Haidian, beijing (CN); GIGADEVICE SEMICONDUCTOR (HEFEI) INC., Hefei, Anhui (CN); GIGADEVICE SEMICONDUCTOR (SHANGHAI) INC., Shanghai 201210 (CN); SILEAD INC., Shanghai 201210 (CN); SHENZHEN GEYI JUCHUANG INTEGRATED CIRCUIT CO., LTD., Nanshan District, Shenzhen (CN); SUZHOU FREETHINK INFORMATION TECHNOLOGY CO., LTD., Suzhou (CN); GIGADEVICE SEMICONDUCTOR (XIAN) INC., Xi'an (CN)
(72) Inventor: LIU, Xing, Beijing (CN); LIU, Sanlin, Beijing (CN)
(74) Representative: dompatent

(57) **Abstract**

A spread spectrum fractional-N control circuit, a fractional-N PLL and a chip are provided. The spread spectrum fractional-N control circuit includes a spread spectrum circuit, a signal modulator and a frequency division control signal output circuit. The spread spectrum circuit processes the superimposition based on a corresponding spread spectrum mode to obtain a corresponding first frequency division control signal, and the processing of the first superimposition is different from each other in a non-spread spectrum mode and different spread spectrum modes (including center- and down-spread spectrum modes). This enables the present invention to support the non-spread and spread spectrum modes and provide an effective spread spectrum function even at a fractional-N ratio close to 0 or 1. Therefore, good phase noise suppression can be achieved at a high frequency and resolution. Moreover, flexible configuration is allowed.

## Description

### TECHNICAL FIELD

The present invention relates to the field of integrated circuit technology and, in particular to, a spread spectrum fractional-N control circuit, a fractional-N phase-locked loop (PLL) and a chip.

### BACKGROUND

High-speed frequency sources are major contributors of electromagnetic interference (EMI) in electronic circuits, which adversely affects system performance and stability. Effective EMI suppression can be achieved by various methods for high-speed digital systems, for example, by using a high-order filter, power-supply decoupling, a good clock line layout, ground wire and power ground isolation, using a clock buffer, or otherwise. For systems operating based on a clock output from a phase-locked loop (PLL), fractional-N division and spread spectrum may be utilized to spread EMI in the output clock over a wider frequency band. This can effectively mitigate EMI, improving system reliability and stability.

Although some existing spread spectrum control circuits provide combined fractional-N and spread spectrum functions by using phase delay compensation, they suffer from the problem of phase spurs (reflecting the degree of interference from fractional spurs), which makes them impossible to provide desirable phase noise performance at a high frequency and resolution.

There are also some existing spread spectrum control circuits, in which a Σ-Δ modulator applies cyclic modulation to a fractional-N divider for providing both fractional-N and spread spectrum functions, resulting in a reduced degree of interference from fractional spurs in the modulated output. However, with this design, center-spread spectrum can be achieved over a very limited range, distortion may occur above or below the center frequency at a fractional-N ratio close to 0 or 1. In other words, the spread spectrum function is not available at a fractional-N ratio close to 0 or 1, leading to a limited range of application.

Therefore, there is an urgent need for a new scheme combining fractional-N and spread spectrum functions, which is more immune against signal spurs found in conventional fractional-N techniques and more flexible in configuration, making it possible to provide effective spread spectrum at a fractional-N ratio close to 0 or 1 and hence desirable phase noise suppression at a high frequency and resolution.

### SUMMARY OF THE INVENTION

It is an object of the present invention to provide a spread spectrum fractional-N control circuit, a fractional-N phase-locked loop (PLL) and a chip, which combine fractional-N and spread spectrum functions and provide high configuration flexibility.

To this end, the present invention provides a spread spectrum fractional-N control circuit comprising:
a spread spectrum circuit configured to superimpose an (n+1)-bit fractional-N control signal and a corresponding triangular wave signal in a corresponding spread spectrum mode, thereby obtaining a first superimposition, wherein a corresponding processing of the first superimposition is performed based on the spread spectrum mode to obtain a corresponding first frequency division control signal, and wherein the processing of the first superimposition is different from each other in a non-spread spectrum mode and different spread spectrum modes;
a signal modulator coupled to the spread spectrum circuit and configured to modulate and shape the first frequency division control signal; and
a frequency division control signal output circuit coupled to the signal modulator and a corresponding fractional-N divider, wherein the frequency division control signal output circuit is configured to provide a second frequency division control signal to the fractional-N divider according to an output from the signal modulator, wherein the fractional-N divider is configured to divide a frequency of a corresponding clock signal based on the second frequency division control signal.

Optionally, the first superimposition may be initially equal to MFN[n:0], incremented by MODSTEP in each clock cycle of a feedback clock signal from the fractional-N divider until it becomes equal to a maximum value, and then decremented by MODSTEP in each clock cycle of the feedback clock signal until it becomes again equal to MFN[n:0],
wherein the maximum value is MFN[n:0]+MODSTEP*MODCNT, where MFN[n:0] is the (n+1)-bit fractional-N control signal, MODSTEP is a spread spectrum modulation step size configured by a register, and MODCNT is a spread spectrum modulation step count configured by a register.

Optionally, a value of MODCNT configured by the register may be calculated according to a modulation frequency for the spread spectrum mode and a reference clock signal, and a value of MODSTEP configured by the register may be calculated according to a modulation depth for the spread spectrum mode, the (n+1)-bit fractional-N control signal and a corresponding integer-N control signal.

Optionally, the spread spectrum circuit may subtract different first subtrahends from the first superimposition in the non-spread spectrum mode and the different spread spectrum mode, thereby achieving different processing in the non-spread spectrum mode and the different spread spectrum modes, wherein the first subtrahend is configured by a second register or is calculated according to values of MODSTEP and MODCNT, where MODSTEP is a spread spectrum modulation step size configured by a register, and MODCNT is a spread spectrum modulation step count configured by a register.

Optionally, the first subtrahend may be equal to 0 in the non-spread spectrum mode, to MODSTEP*MODCNT/2 in a center-spread spectrum mode, or to MODSTEP*MODCNT in a down-spread spectrum mode.

Optionally, the spread spectrum circuit may comprise:
a triangular wave generator configured to generate and output the triangular wave signal corresponding to the (n+1)-bit fractional-N control signal in the corresponding spread spectrum mode;
a second accumulator coupled to the triangular wave generator and the (n+1)-bit fractional-N control signal, the second accumulator configured to superimpose the output from the triangular wave generator and the (n+1)-bit fractional-N control signal and thereby output the first superimposition; and
a subtractor coupled to the second accumulator and configured to subtract the first subtrahend from the first superimposition output from the second accumulator, thereby obtaining the first frequency division control signal.

Optionally, the spread spectrum circuit may be further configured to extend a result of the processing by k bits and thereby output an (n+k+1)-bit the first frequency division control signal, where n and k are both integers and satisfy n≥0 and k≥2, respectively.

Optionally, n may be equal to 13 and k may be equal to 2.

Optionally, the spread spectrum circuit may further comprise a first register storing an (n+k+1)-bit additional value, wherein the spread spectrum circuit is further configured to superimpose the first superimposition or the result of the processing and the additional value and thereby extend the result of the processing by k bits.

Optionally, the spread spectrum fractional-N control circuit may further comprise:
a signal splitter circuit coupled to the spread spectrum circuit and configured to split k most significant bits (MSBs) of the (n+k+1)-bit first frequency division control signal from a remaining (n+1) least significant bits (LSBs) of the (n+k+1)-bit first frequency division control signal, thereby obtaining a k-MSB signal and an (n+1)-LSB signal; and
a k-MSB delay circuit coupled to the signal splitter circuit and the frequency division control signal output circuit, the k-MSB delay circuit configured to delay the k-MSB signal output from the signal splitter circuit and provide it to the frequency division control signal output circuit,
wherein the signal modulator is further configured to modulate and shape the (n+1)-LSB signal output from the signal splitter circuit; the output from the signal modulator is synchronized with the output from the k-MSB delay circuit; and
the frequency division control signal output circuit is further configured to superimpose the output from the signal modulator and the output from the k-MSB delay circuit.

Optionally, the k-MSB delay circuit may comprise a delay chain comprising a cascade of at least two first delay units, wherein a stage count of first delay units matches a modulation duration of the signal modulator.

Optionally, the first delay unit may be a k-bit register. Additionally or alternatively, the stage count of the first delay units is three, wherein the signal modulator is a third-order multi-stage noise shaping (MASH) sigma-delta modulator (SDM).

Optionally, the frequency division control signal output circuit may further be configured to superimpose the output from the k-MSB delay circuit, the output from the signal modulator and a corresponding integer-N control signal and then to subtract a k-bit second subtrahend from the resulting superimposition, thereby obtaining the second frequency division control signal superimposed with integer-N control signal.

Optionally, the frequency division control signal output circuit may comprise:
a third accumulator coupled to the signal modulator and the k-MSB delay circuit, the third accumulator configured to superimpose the output from the k-MSB delay circuit and the output from the signal modulator;
a third register for configuring the second subtrahend;
a fourth accumulator coupled to the third accumulator, the third register and the corresponding integer-N control signal, the fourth accumulator configured to sum an output from the third accumulator and the integer-N control signal and then to subtract the second subtrahend; and
an output register coupled to the fourth accumulator and configured to synchronize an output from the fourth accumulator with the feedback clock signal feedbacking from the fractional-N divider and thereby to output the second frequency division control signal.

Optionally, the spread spectrum fractional-N control circuit may further comprise a pseudo-random sequence generator configured to generate and output a pseudo-random sequence, wherein the spread spectrum circuit further comprises a first accumulator coupled to the (n+1)-bit fractional-N control signal and the pseudo-random sequence generator, the first accumulator configured to: superimpose the (n+1)-bit fractional-N control signal and the pseudo-random sequence to obtain a second superimposition; and superimpose the second superimposition and the triangular wave signal, thereby obtaining the first superimposition.

Optionally, the spread spectrum circuit may further be coupled to an enable signal, a spread spectrum mode control signal and a spread spectrum direction control signal, and provide following operation modes depending the enable signal, the spread spectrum mode control signal and the spread spectrum direction control signal:
(1) an integer-N-only mode, in which the enable signal is at a first level;
(2) a fractional-N mode without spread spectrum, in which the enable signal is at a second level and the spread spectrum mode control signal is at the second level; and
(3) a spread spectrum mode, in which the enable signal is at the second level and the spread spectrum mode control signal is at the first level, and which is a center-spread spectrum mode if the spread spectrum direction control signal is at the first level, or a down-spread spectrum mode if the spread spectrum direction control signal is at the second level.

Optionally, depending on the (n+1)-bit fractional-N control signal MFN[n:0] and the spread spectrum direction control signal, the spread spectrum circuit further distinguishes the different spread spectrum modes into following modes:
(3-1) a center-spread spectrum mode with integer-N division, in which the spread spectrum direction control signal is at the first level and MFN[n:0]=0;
(3-2) a down-spread spectrum mode with integer-N division, in which the spread spectrum direction control signal is at the second level and MFN[n:0]=0;
(3-3) a center-spread spectrum mode with fractional-N division, in which the spread spectrum direction control signal is at the first level and MFN[n:0] ≠0; and
(3-4) a down-spread spectrum mode with fractional-N division, in which the spread spectrum direction control signal is at the second level and MFN[n:0] ≠0.

Based on the same inventive concept, the present invention also provides a fractional-N PLL comprising a prescaler, a phase-frequency detector, a charge pump, a low-pass filter and a voltage-controlled oscillator (VCO), which are connected in sequence. The fractional-N PLL further comprises a fractional-N divider and the spread spectrum fractional-N control circuit as defined above. An output of the fractional-N divider is coupled to a feedback input of the phase-frequency detector. A first input of the fractional-N divider is coupled to an output of the VCO, and a second input of the fractional-N divider is coupled to an output of the spread spectrum fractional-N control circuit.

Based on the same inventive concept, the present invention also provides a chip comprising the PLL of the present invention.

Compared with the prior art, the present invention offers at least the following advantages:
1. It provides a spread spectrum fractional-N control circuit including a spread spectrum circuit, a signal modulator and a frequency division control signal output circuit. The spread spectrum circuit can superimpose an (n+1)-bit fractional-N control signal and a corresponding triangular wave signal in a corresponding spread spectrum mode, and a corresponding processing of the first superimposition is performed based on the spread spectrum mode to obtain a corresponding first frequency division control signal. Moreover, the spread spectrum circuit processes the superimposition in different manners in a non-spread spectrum mode (e.g., an integer-N-only mode or a fractional-N mode without spread spectrum) and different spread spectrum modes (e.g., center- and down-spread spectrum modes). After being modulated and shaped by the signal modulator, the first frequency division control signal is output as a second frequency division control signal from the frequency division control signal output circuit. The fractional-N divider then divides the frequency of a clock signal based on the second frequency division control signal. With this arrangement, the present invention can support various non-spread and spread spectrum modes, while providing an effective spread spectrum function even at a fractional-N ratio close to 0 or 1. Thus, good phase noise suppression can be achieved at a high frequency and resolution.
2. Values of a step size MODSTEP and count MODCNT for spread spectrum modulation stored in registers can be calculated and configured according to a spread spectrum modulation frequency and modulation amplitude, if required, resulting in higher configuration flexibility and a wider range of application.
3. The spread spectrum fractional-N control circuit of the present invention can extend a result of processing from the spread spectrum circuit by k bits, thereby avoiding signal overflow that may arise from the use of fractional-N division in combination with spread spectrum modulation.

### BRIEF DESCRIPTION OF THE DRAWINGS

Those of ordinary skill in the art will understand that the following drawings are presented to enable a better understanding of the present invention and not intended to limit the scope thereof in any sense, in which:
Fig. 1 schematically illustrates the architecture of a PLL circuit according to a first embodiment of the present invention;
Fig. 2 schematically illustrates the architecture of a spread spectrum fractional-N control circuit according to the first embodiment of the present invention;
Fig. 3 schematically illustrates an example configuration of a spread spectrum circuit in the spread spectrum fractional-N control circuit according to the first embodiment of the present invention;
Fig. 4 schematically illustrates center-spread spectrum provided by the spread spectrum circuit in the spread spectrum fractional-N control circuit according to the first embodiment of the present invention;
Fig. 5 schematically illustrates down-spread spectrum provided by the spread spectrum circuit in the spread spectrum fractional-N control circuit according to the first embodiment of the present invention;
Fig. 6 schematically illustrates an example configuration of a signal modulator in the spread spectrum fractional-N control circuit according to the first embodiment of the present invention;
Fig. 7 schematically illustrates an example configuration of a third delay element in the signal modulator in the spread spectrum fractional-N control circuit according to the first embodiment of the present invention;
Fig. 8 schematically illustrates an example configuration of a frequency division control signal output circuit in the spread spectrum fractional-N control circuit according to the first embodiment of the present invention;
Fig. 9 schematically illustrates the architecture of a spread spectrum fractional-N control circuit according to a second embodiment of the present invention;
Fig. 10 schematically illustrates an example configuration of a spread spectrum circuit in the spread spectrum fractional-N control circuit according to the second embodiment of the present invention;
Fig. 11 schematically illustrates an example configuration of a k-MSB delay circuit in the spread spectrum fractional-N control circuit according to the second embodiment of the present invention;
Fig. 12 schematically illustrates an example configuration of a frequency division control signal output circuit in the spread spectrum fractional-N control circuit according to the second embodiment of the present invention; and
Fig. 13 schematically illustrates an example configuration of the spread spectrum fractional-N control circuit according to the second embodiment of the present invention (where n=13, k=2 and m=7).

### DETAILED DESCRIPTION

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is understood that the invention may be embodied in many different forms and should not be construed as being limited to the embodiments set forth herein. Rather, these embodiments are provided so that this disclosure is thorough and conveys the scope of the invention to those skilled in the art. In the drawings, same reference numerals refer to same elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

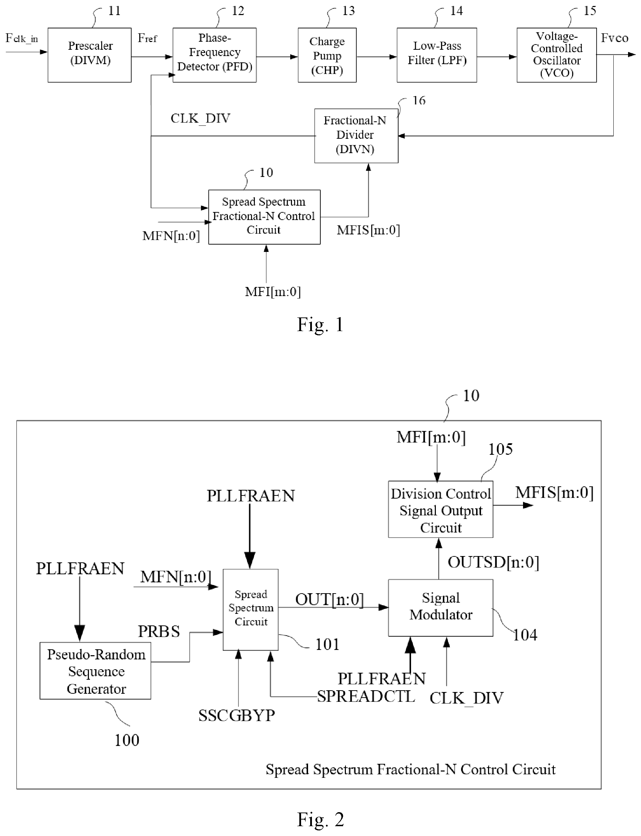

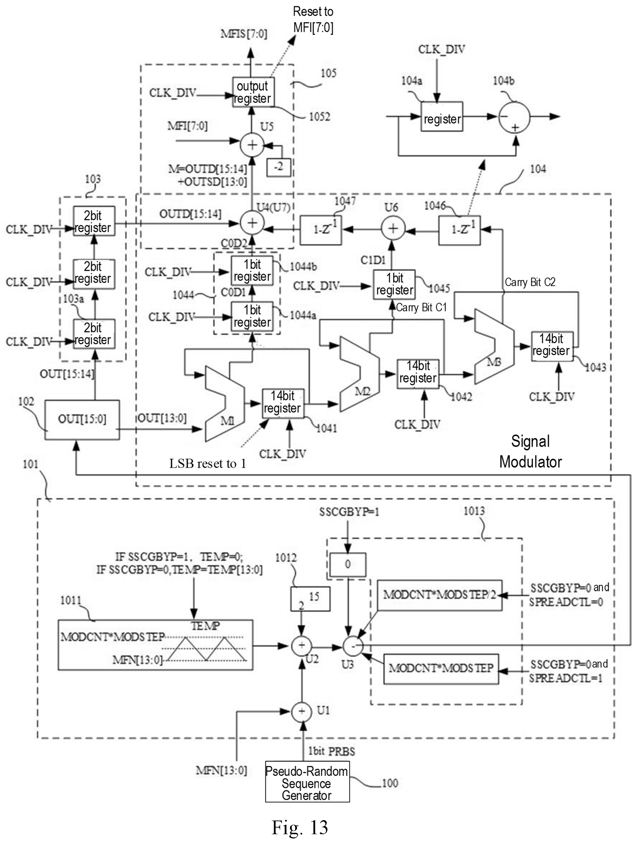

The present invention will be described in detail below by way of specific examples with reference to Figs. 1 to 13.

### Embodiment 1

Referring to Fig. 1, in one embodiment of the present invention, there are provided a spread spectrum fractional-N control circuit 10 and a fractional-N phase-locked loop (PLL) incorporating the spread spectrum fractional-N control circuit 10. That is, in this embodiment, the spread spectrum fractional-N control circuit 10 is provided in the fractional-N PLL.

In one example, referring to Fig. 1, the fractional-N PLL of this embodiment includes, connected in sequence, a prescaler (DIVM, also referred to as a "front-end divider") 11, a phase-frequency detector (PFD) 12, a charge pump (CHP) 13, a low-pass filter (LPF, also referred to as "loop filter") 14 and a voltage-controlled oscillator (VCO) 15. It also includes a fractional-N divider (DIVN) 16 and the spread spectrum fractional-N control circuit 10. A first input of the fractional-N divider (DIVN) 16 is coupled to an output of the VCO 15, and a second input thereof is coupled to an output of the spread spectrum fractional-N control circuit 10.

The prescaler 11 divides the frequency (F_{clk_in}) of a clock signal input from an external clock, producing a reference clock signal (not shown) at a reference frequency F_{ref}, which is then fed to the phase-frequency detector 12.

The phase-frequency detector 12 is based on the reference clock signal (F_{ref}) from the prescaler 11 and a feedback clock signal CLK_DIV from the fractional-N divider (DIVN) 16 to generate a charge/discharge signal (not shown) with a phase difference.

The charge pump 13 is controlled by the charge/discharge signal from the phase-frequency detector 12 to generate a bias current.

The low-pass filter 14 is based on the bias current from the charge pump 13 to generate a control voltage (not shown).

The VCO 15 is based on the control voltage from the low-pass filter 14 to generate a clock signal (at a frequency F_{vco}).

The spread spectrum fractional-N control circuit 10 is configured to enter a mode (e.g., an integer-N-only mode, a fractional-N mode without spread spectrum, a center-spread spectrum mode with integer-N division, a down-spread spectrum mode with integer-N division, a center-spread spectrum mode with fractional-N division, a down-spread spectrum mode with fractional-N division, etc.), depending control signals (including a fractional-N control signal MFN[n:0], an integer-N control signal MFI[m:0], an enable signal PLLFRAEN, a spread spectrum mode control signal SSCGBYP, a spread spectrum direction control signal SPREADCTL, etc.), and is based on these control signals and the feedback clock signal CLK_DIV from the fractional-N divider 16 to dynamically modify a second frequency division control signal MFIS[m:0] that it generates and outputs so that an average frequency division ratio of the fractional-N divider 16 is maintained at a preset fractional value.

The fractional-N divider 16 is based on the second frequency division control signal MFIS[m:0] from the spread spectrum fractional-N control circuit 10 to divide the frequency (F_{vco}) of the clock signal from the VCO 15, generating a feedback clock signal CLK_DIV. Both m and n are integers, and m is equal to (n+1)/2 or any other suitable value. The feedback clock signal CLK_DIV is desired to have a frequency equal to F_{pfd}, at which the phase-frequency detector 12 carries out phase detection (the latter is in turn equal to F_{ref}). The frequency F_{ref} of the reference clock signal (i.e., the reference frequency) can be expressed as: ${F}_{ref} = {F}_{clk _ in} / DIVM ,$ where DIVM represents a frequency division ratio of the prescaler 11.

After the fractional-N PLL is activated, the frequency of the feedback clock signal CLK_DIV will gradually approach, and be eventually locked at, the frequency F_{ref} of the reference clock signal. The feedback clock signal CLK_DIV is provided to the spread spectrum fractional-N control circuit 10, as a reference clock signal for fractional-N division and spread spectrum.

The low-pass filter 14 can effectively filter out phase spurs in the output of the phase-frequency detector 12, thereby modifying the control voltage for the VCO 15 and locking an output frequency F_{pll_VCO} of the VCO 15 at a desired value.

On the other hand, when the output frequency F_{pil_VCO} of the VCO 15 is exactly n±(b/A) times the phase-detection frequency F_{pfd} for the phase-frequency detector 12 (which is equal to F_{ref}), spurious frequencies will be closest to that of the main signal, with only minor differences from that of the main signal (e.g., as small as 1/M3 F_{pfd}), and therefore generally could not be filtered out by the low-pass filter 14. In this case, the VCO 15 will be most strongly interfered by fractional spurs. In addition, since the fractional-N PLL operates at a high frequency in short cycles, it more tends to become an EMI contributor.

In order to effectively suppress EMI from the fractional-N PLL, in this embodiment, the spread spectrum fractional-N control circuit 10 performs spread-spectrum processing on the feedback clock signal CLK_DIV from the fractional-N divider. Such a combination of fractional-N and spread spectrum functions can dynamically modify the frequency division ratio of the fractional-N divider 16 so that an average frequency division ratio of the fractional-N divider 16 is maintained at a preset fractional value, to prevent conflict between the frequency division ratios in the fractional-N mode and the spread spectrum mode.

Referring to Fig. 2, in one example, the spread spectrum fractional-N control circuit 10 includes a pseudo-random sequence generator 100, a spread spectrum circuit 101, a signal modulator 104 and a frequency division control signal output circuit 105. In other examples, if required, the pseudo-random sequence generator 100 may be omitted from the spread spectrum fractional-N control circuit 10.

The pseudo-random sequence generator 100 is configured to generate and output a pseudo-random sequence PRBS with "random" properties and having a period length optionally related to a bitwidth of the pseudo-random sequence generator 100 (also known as its order). The greater the bitwidth is, the greater the period length of the pseudo-random sequence PRBS may be. In each period, the pseudo-random sequence generator 100 may output a pseudo-random sequence PRBS forming a bit stream consisting of equal numbers of binary 1's and 0's, which are distributed randomly in the stream. The spectral properties of the bit stream approximate spectral properties of white noise. Adding such pseudo-random sequences 100 enables the spread spectrum fractional-N control circuit 10 to spread quantization noise more uniformly over a higher frequency band, provide an improved signal-to-noise ratio and be less susceptible to the impact of quantization errors. Optionally, the pseudo-random sequence generator 100 may be a 32-bit linear-feedback shift register (LFSR), which can produce a pseudo-random sequence PRBS by performing an XOR operation or the like.

The spread spectrum circuit 101 is coupled to an (n+1)-bit fractional-N control signal MFN[n:0] and the pseudo-random sequence generator 100 and configured to superimpose the (n+1)-bit fractional-N control signal MFN[n:0] and the pseudo-random sequence generator 100 in a spread spectrum mode, obtaining a second superimposition (not shown). It is also configured to superimpose the second superimposition and a triangular wave signal TEMP, obtaining a first superimposition (not shown). It is further configured to process the first superimposition based on the spread spectrum mode, obtaining an (n+1)-bit first frequency division control signal OUT[(n+k):0], where n≥0, k≥2 and n and k are both integers. In a non-spread spectrum mode, the second superimposition may not be superimposed with a triangular wave signal TEMP (alternatively, in this case, the triangular wave signal TEMP may be considered to be superimposed with a triangular wave signal TEMP which is constantly zero). Moreover, in non-spread and spread spectrum modes (each spread spectrum mode may be associated with a different spread spectrum direction, such as center- or down-spread spectrum), the spread spectrum circuit 101 may process the first superimposition in any suitable manners, which are different from one another. An enable signal PLLFRAEN received by the spread spectrum circuit 101 may determine which one of non-spread and spread spectrum modes is to be used. For example, if PLLFRAEN=0 (i.e., if the enable signal is low), the spread spectrum circuit 101 may operate in a non-spread spectrum mode, which may be either an integer-N-only mode (i.e., an integer-N mode without spread spectrum), or a fractional-N mode without spread spectrum (i.e., a fractional-N-only mode). If PLLFRAEN=1 (i.e., if the enable signal is high), the spread spectrum circuit 101 may operate in a spread spectrum mode, which may be combined with integer-N division (i.e., an integer-N mode with spread spectrum), or with fractional-N division (i.e., a fractional-N mode with spread spectrum). Further, in the spread spectrum mode combined with fractional-N division, the integer part may be zero (i.e., MFI[m:0]=0) or non-zero (i.e., MFI[m:0]≠0).

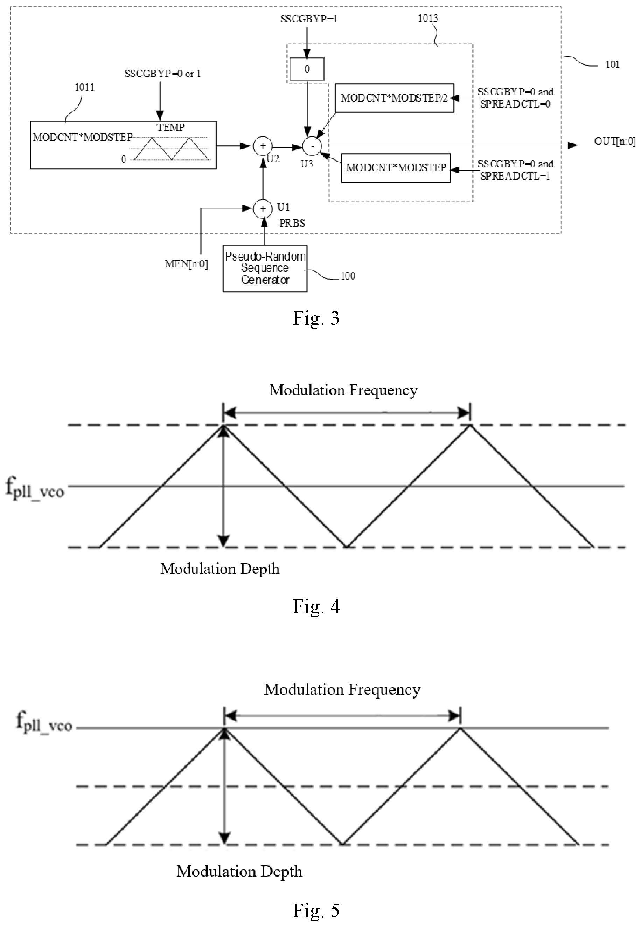

Optionally, referring to Fig. 3, the spread spectrum circuit 101 may substract, in non-spread and spread spectrum modes, different first subtrahends from the first superimposition, thereby achieving different processing for the non-spread and different spread spectrum modes. The first subtrahend may be stored in a second register 1013, or calculated from MODSTEP and MODCNT each stored in a register, where MODSTEP represents a spread spectrum modulation step size, and MODCNT represents a spread spectrum modulation step count.

Referring to Fig. 3, in one example, in a non-spread spectrum mode (e.g., the enable signal PLLFRAEN=0 and a spread spectrum mode control signal SSCGBYP=x, where x is 0, 1 or any of other possible values; or PLLFRAEN=1 and SSCGBYP=1), the first subtrahend may be set to 0. In a center-spread spectrum mode (e.g., PLLFRAEN=1, SSCGBYP=0 and a spread spectrum direction control signal SPREADCTL=0), the first subtrahend may be set to MODSTEP*MODCNT/2. In a down-spread spectrum mode (e.g., PLLFRAEN=1, SSCGBYP=0 and SPREADCTL=1), the first subtrahend may be set to MODSTEP*MODCNT.

In one example, referring to Fig. 3, the spread spectrum circuit 101 includes a first accumulator U1, a triangular wave generator 1011, a second accumulator U2, a second register 1013 and a subtractor U3.

A first input of the first accumulator U1 is coupled to an (n+1)-bit fractional-N control signal MFN[n:0], and a second input thereof is coupled to an output of the pseudo-random sequence generator 100. The first accumulator U1 is configured to superimpose the (n+1)-bit fractional-N control signal MFN[n:0] and a pseudo-random sequence PRBS from the pseudo-random sequence generator 100, obtaining a second superimposition (i.e., a superimposition of the fractional-N control signal and the pseudo-random sequence), and to provide the second superimposition to one input of the second accumulator U2.

The triangular wave generator 1011 is coupled to a spread spectrum mode control signal SSCGBYP and a feedback clock signal CLK_DIV from the fractional-N divider 16, and is based on a feedback clock signal CLK_DIV to generate and output a triangular wave signal TEMP associated with the (n+1)-bit fractional-N control signal MFN[n:0] in a spread spectrum mode (e.g., PLLFRAEN=1 and SSCGBYP=0). Alternatively, in a non-spread spectrum mode (e.g., PLLFRAEN=0 and SSCGBYP=x; or PLLFRAEN=1 and SSCGBYP=1), it outputs TEMP=0. In the spread spectrum mode (e.g., PLLFRAEN=1 and SSCGBYP=0), the triangular wave generator 1011 may generate the triangular wave signal TEMP, which is initially zero and takes the feedback clock signal CLK_DIV from the fractional-N divider 16 as a reference clock signal. This operation is described in detail below with reference to Figs. 1 to 3.

The triangular wave signal TEMP is initially zero and takes the feedback clock signal CLK_DIV as a reference clock signal. Based on the spread spectrum modulation step size MODSTEP configured by the register, upon the arrival of a rising edge of the feedback clock signal CLK_DIV in each clock cycle, TEMP is incremented by a MODSTEP. The number of the increments is a spread spectrum modulation step count MODCNT configured by the register, and TEMP is incremented up to a maximum value MODSTEP*MODCNT. Then, TEMP is decremented by MODSTEP upon the arrival of a rising edge in each clock cycle of the feedback clock signal CLK_DIV until it drops to the initial value 0. One period of the triangular wave signal TEMP is formed by incrementing from 0 to the maximum value MODSTEP*MODCNT and then decrementing back to 0.

A first input of the second accumulator U2 is coupled to an output of the triangular wave generator 1011, and a second input thereof is coupled to an output of the first accumulator U1 (i.e., to the second superimposition of the (n+1)-bit fractional-N control signal MFN[n:0] and the pseudo-random sequence PRBS). The second accumulator U2 is configured to superimpose a triangular wave signal TEMP from the triangular wave generator 1011 and the output of the first accumulator U1 (i.e., the (n+1)-bit fractional-N control signal MFN[n:0] superimposed with the pseudo-random sequence PRBS), to output a first superimposition.

Accordingly, the first superimposition output from the second accumulator U2 in a spread spectrum mode (e.g., center- or down-spread spectrum) is also a triangular wave signal. With the (n+1)-bit fractional-N control signal MFN[n:0] as an initial value, the first superimposition is incremented by MODSTEP in each clock cycle of the feedback clock signal CLK_DIV from the fractional-N divider 16 until it reaches MFN[n:0]+MODSTEP*MODCNT. That is, the number of increments is equal to MODCNT. After that, the first superimposition is decremented by MODSTEP in each clock cycle of the feedback clock signal CLK_DIV until it again becomes equal to the (n+1)-bit fractional-N control signal MFN[n:0]. The number of decrements is also equal to MODCNT. MODSTEP represents a spread spectrum modulation step size configured by a register, and MODCNT represents a spread spectrum modulation step count configured by a register.

In other words, in this embodiment, the fractional-N PLL may operate in a spread spectrum mode (e.g., PLLFRAEN=1 and SSCGBYP=0) with a spread spectrum modulation frequency and depth determined by MODSTEP and MODCNT, respectively.

A first input of the subtractor U3 is coupled to an output of the second accumulator U2, and a second input thereof is coupled to the second register 1013. Optionally consisting of a bank of registers, the second register 1013 is coupled to a spread spectrum mode control signal SSCGBYP and a spread spectrum direction control signal SPREADCTL and used to configure a first subtrahend required for the current spread spectrum mode. The subtractor U3 is configured to subtract the first subtrahend that is stored in the second register 1013 from the output of the second accumulator U2, thereby producing a first frequency division control signal OUT[(n+k):0]. The first subtrahend in the second register 1013 is configured to different values in the non-spread and spread spectrum modes.

In one example, in a non-spread spectrum mode (e.g., PLLFRAEN=1 and SSCGBYP=1), the first subtrahend configured by the second register 1013 may be set to 0. In a center-spread spectrum mode (e.g., PLLFRAEN=1, SSCGBYP=0 and SPREADCTL=0), the first subtrahend configured by the second register 1013 may be set to MODSTEP*MODCNT/2. In a down-spread spectrum mode (e.g., PLLFRAEN=1, SSCGBYP=0 and SPREADCTL=1), the first subtrahend configured by the second register 1013 may be set to MODSTEP*MODCNT. Here, MODCNT represents a spread spectrum modulation step count configured by a register, and MODSTEP represents a spread spectrum modulation step size configured by a register.

Optionally, MODCNT may be calculated according to a modulation frequency f_{MOD} and a reference clock frequency F_{ref} of the current spread spectrum mode, and MODSTEP may be calculated according to a modulation depth MD of the current spread spectrum mode, an (n+1)-bit fractional-N control signal MFN[n:0] and an associated (m+1)-bit integer-N control signal MFI[m:0]. In particular, these calculations may be performed according to: $MODCNT = {F}_{clk _ in} / \left(DIVM*2*{f}_{MOD}\right) ;$ and $MODSTEP = MD * LDF * {2}^{n + 1} / \left(100*MODCNT\right) ,$ where m is an integer ≥0, F_{clk_in} is the frequency of a clock signal input from an external clock to the fractional-N PLL, f_{MOD} is a spread spectrum modulation frequency, DIVM is the frequency division ratio of the prescaler 11, MD is a spread spectrum modulation depth in percent and LDF is a fractional-N division ratio. Also satisfied are: LDF=MFN+MFI/2ⁿ⁺¹; and Fref=F_{clk_in}/DIVM.

Referring to Figs. 2 and 3, the aforementioned control signals, including the enable signal PLLFRAEN, the spread spectrum mode control signal SSCGBYP, the spread spectrum direction control signal SPREADCTL, the (n+1)-bit fractional-N control signal MFN[n:0] and the integer-N control signal MFI[m:0], may be each configured by a respective register. The (n+1)-bit fractional-N control signal MFN[n:0] may be provided by an (n+1)-bit fractional-N configuration register.

In this embodiment, depending on configurations of the enable signal PLLFRAEN, the spread spectrum mode control signal SSCGBYP, the spread spectrum direction control signal SPREADCTL, the (n+1)-bit fractional-N control signal MFN[n:0] and the integer-N control signal MFI[m:0] (where m is an integer ≥0), the spread spectrum fractional-N control circuit 10 may operate in one of the following modes:
(1) Integer-N-Only, where MFI[m:0]≠0, MFN[n:0]=0, PLLFRAEN=0 (i.e., PLLFRAEN is at a first level) and SSCGBYP=x (x is 0, 1 or any of other possible values, indicating that SSCGBYP is at a second, first or other level). That is, regardless of what level SSCGBYP is at, the circuit enters this mode as long as PLLFRAEN is at the first level. For example, when PLLFRAEN=0, the entire fractional-N and spread spectrum link may be deactivated. This mode is a non-spread spectrum mode, i.e., an integer-N mode not combined with spread spectrum. In this mode, TEMP is constantly zero (TEMP =0, i.e., the triangular wave generator 1011 does not output a triangular wave signal).
(2) Fractional-N without Spread Spectrum (Fractional-N-Only), where PLLFRAEN=1 (i.e., PLLFRAEN is at the second level) and SSCGBYP=1 (i.e., SSCGBYP is at the second level). This is another non-spread spectrum mode, in which the fractional-N control signal MFN[n:0]≠0. In this mode, the integer-N control signal MFI[m:0] may be zero (i.e., the fractional-N mode is not combined with an integer-N function) or non-zero (i.e., the fractional-N mode is combined with only an integer-N function).
(3) Spread Spectrum, where PLLFRAEN=1 (i.e., PLLFRAEN is at the second level), SSCGBYP=0 (i.e., SSCGBYP is at the first level). This is a center-spread spectrum mode if the spread spectrum direction control signal SPREADCTL=0 (i.e., at the first level), or a down-spread spectrum mode if the spread spectrum direction control signal SPREADCTL=1 (i.e., at the second level). Depending on the fractional-N control signal MFN[n:0] and the spread spectrum direction control signal SPREADCTL, it may also be one of the following modes:
   (3-1) Center-Spread Spectrum with Integer-N, where PLLFRAEN=1 (i.e., PLLFRAEN is at the second level), SSCGBYP=0 (i.e., SSCGBYP is at the first level), SPREADCTL=0 (i.e., SPREADCTL is at the first level) and MFN[n:0]=0;
   (3-2) Down-Spread Spectrum with Integer-N, where PLLFRAEN=1 (i.e., PLLFRAEN is at the second level), SSCGBYP=0 (i.e., SSCGBYP is at the first level), SPREADCTL=1 (i.e., SPREADCTL is at the second level) and MFN[n:0]=0;
   (3-3) Center-Spread Spectrum with Fractional-N, where PLLFRAEN=1 (i.e., PLLFRAEN is at the second level), SSCGBYP=0 (i.e., SSCGBYP is at the first level), SPREADCTL=0 (i.e., SPREADCTL is at the first level) and MFN[n:0]≠0; and
   (3-4) Down-Spread Spectrum with Fractional-N, where PLLFRAEN=1 (i.e., PLLFRAEN is at the second level), SSCGBYP=0 (i.e., SSCGBYP is at the first level), SPREADCTL=1 (i.e., SPREADCTL is at the second level) and MFN[n:0]≠0.

Notably, in each of the spread spectrum modes with fractional-N division (i.e., (3-3) and (3-4)), the integer-N control signal MFI[m:0] may be 0 (corresponding to the spread spectrum mode being combined only with a fractional-N function, but not with an integer-N function) or non-zero (corresponding to the spread spectrum mode being combined with both integer-N and fractional-N functions).

With combined reference to Figs. 1 to 5, when the spread spectrum fractional-N control circuit 10 is operating in an integer-N mode, the output clock frequency F_{pil_VCO} of the VCO 15 satisfies F_{pll_VCO}=(F_{clk_in}/DIVM)*MFI.

When the spread spectrum fractional-N control circuit 10 is operating in a fractional-N mode (e.g., the mode (2), (3-3) or (3-4), as discussed above), the output clock frequency F_{pil_VCO} of the VCO 15 satisfies F_{pll_VCO}=(F_{clk_in}/DIVM)*[MFI+(MFN+0.5)/2ⁿ⁺¹], where F_{clk_in} is the frequency of a clock signal input from an external clock (i.e., a clock source), MFN is an (n+1)-bit fractional-N control signal, DIVM is the frequency division ratio of the prescaler 11, and MFI is an (m+1)-bit integer-N control signal.

A first input of the signal modulator 104 is coupled to an output of the spread spectrum circuit 101, and the signal modulator 104 is configured to modulate and shape the (n+1)-bit first frequency division control signal OUT[n:0] from the spread spectrum circuit 101. The signal modulator 104 may be of any suitable circuit design.

Optionally, the signal modulator 104 may be implemented as a third-order SDM (also known as a sigma (Σ)-delta (Δ) modulator or a Δ-Σ modulator). Possible MASH configurations include, but are not limited to, MASH1-1, MASH2-1 and MASH1-1-1. SDMs are modulators that utilize oversampling and noise shaping techniques to provide increased signal resolution. Basic SDM operations generally include oversampling, feedback-loop-based noise shaping and digital filtering and decimation.

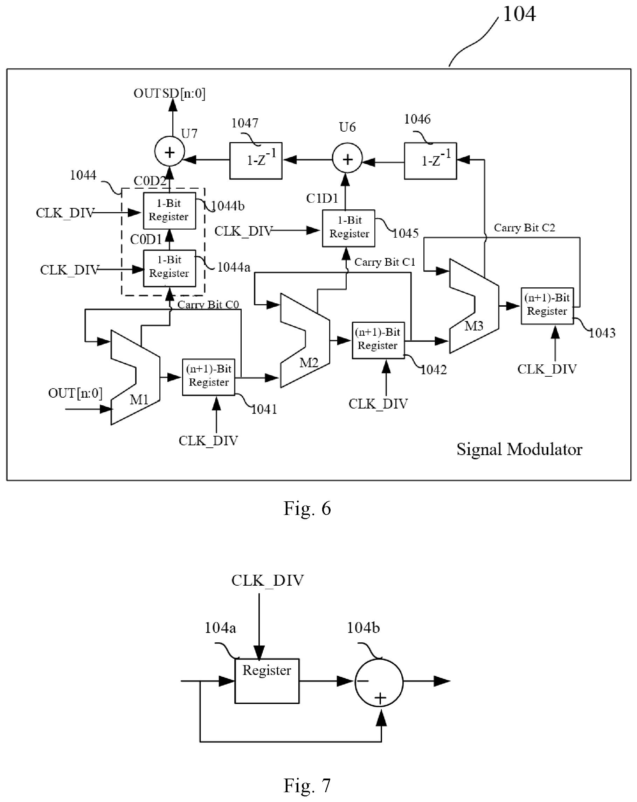

In one example, referring to Fig. 6, the signal modulator 104 is a third-order MASH1-1-1 modulator including first to third accumulator stages M1 to M3, delays 1041 to 1043, a delay chain 1044, delays 1045 to 1047 and accumulators U6 to U7. Each accumulator stage has a sum output, a carry output and two inputs.

The sum output of the first accumulator stage M1 is coupled to a first input of the second accumulator stage M2 and a first input of the first accumulator stage M1 via the delay 1041. The second input of the first accumulator stage M1 is coupled to the (n+1)-bit first frequency division control signal OUT[n:0] from the spread spectrum circuit 101, and the carry output of the first accumulator stage M1 is coupled to an input of the delay chain 1044. An output of the delay chain 1044 is coupled to a first input of the accumulator U7. The delay chain 1044 is also coupled to the feedback clock signal CLK_DIV. The delay chain 1044 is configured to delay a carry bit C0 from the carry output of the first accumulator stage M1, for example, by two cycles of the feedback clock signal CLK_DIV that is taken as a reference clock signal. The delayed carry bit C0D2 is output at the output of the delay chain 1044. The delay 1041 is also coupled to the feedback clock signal CLK_DIV and configured to delay an output from the sum output of the first accumulator stage M1, with the feedback clock signal CLK_DIV as a reference clock signal. As a result, the output from the sum output of the first accumulator stage M1 outputs the sum of the output delayed by the delay 1041 and OUT[n:0]. If this sum overflows, the first accumulator stage M1 outputs the carry bit C0.

The sum output of the second accumulator stage M2 is coupled to a first input of the third accumulator stage M3 and the second input of the second accumulator stage M2 via the delay 1042. The carry output of the second accumulator stage M2 is coupled to an input of the delay 1045, and an output of the delay 1045 is coupled to a first input of the accumulator U6. The delay 1045 is also coupled to the feedback clock signal CLK_DIV and configured to delay a carry bit C1 from the carry output of the second accumulator stage M2, for example, by one cycle of the feedback clock signal CLK_DIV that is taken as a reference clock signal. The delayed carry bit C1D1 is output at the output of the delay 1045. The delay 1042 is also coupled to the feedback clock signal CLK_DIV and configured to delay an output from the sum output of the second accumulator stage M2, with the feedback clock signal CLK_DIV as a reference clock signal. As a result, the output from the sum output of the second accumulator stage M2 outputs is sum of the output delayed by the delay 1042 and the output from the sum output of the first accumulator stage M1. If this sum overflows, the second accumulator stage M2 outputs the carry bit C1.

The sum output of the third accumulator stage M3 is coupled to a first input of the delay 1043, and an output of the delay 1043 is coupled to the second input of the third accumulator stage M3. The carry output of the third accumulator stage M3 is coupled to an input of the delay 1046, and an output of the delay 1046 is coupled to the second input of the accumulator U6. The delay 1043 is also coupled to the feedback clock signal CLK_DIV and configured to delay an output from the sum output of the third accumulator stage M3, with the feedback clock signal CLK_DIV being taken as a reference clock signal. As a result, the output of the sum output of the third accumulator stage M3 outputs the sum of the output delayed by the delay 1043 and the output from the sum output of the second accumulator stage M2. If this sum overflows, the third accumulator stage M3 outputs a carry bit C2.

Each of the delays 1041 to 1043, the delay chain 1044 and the delays 1045 to 1047 may be of any suitable circuit design. For example, each of the delays 1041 to 1043 may be implemented as an (n+1)-bit register, the delay chain 1044 as cascaded 1-bit registers 1044a and 1044b, and the delay 1045 as a 1-bit register 1044a.

Referring to Fig. 7, each of the delays 1046 and 1047 may consist of a register 104a and a subtractor 104b. The register 104a is also coupled to the feedback clock signal CLK_DIV, in order to delay (e.g., by one cycle) the signal that it receives, with the feedback clock signal CLK_DIV being taken as a reference clock signal. A first input of the subtractor 104b is coupled to an output of the register 104a, and another input thereof is coupled to the signal received at the register 104a, in order to perform a subtraction operation on the input to and output from the register 104a.

As can be seen from Fig. 6, the signal modulator 104 outputs OUTSD[n:0]=C2-C2D1+C1D1-C2D1+C2D2-C1D2+C0D2. When n=13, the output may comprise eight different values [-3, -2, -1, 0, 1, 2, 3, 4].

With combined reference to Figs. 1 and 2, the frequency division control signal output circuit 105 is coupled to the signal modulator 104 and the fractional-N divider (DIVN) 16 in the fractional-N PLL. The frequency division control signal output circuit 105 is configured to superimpose the output OUTSD[n:0] of the signal modulator 104 and an associated integer-N control signal MFI[m:0] and output a second frequency division control signal MFIS[m:0] superimposed with integer-N control signal to the fractional-N divider 16. The fractional-N divider 16 is configured to divide the frequency (F_{vco}) of a clock signal output from the VCO 15 based on the second frequency division control signal MFIS[m:0] from the frequency division control signal output circuit 105.

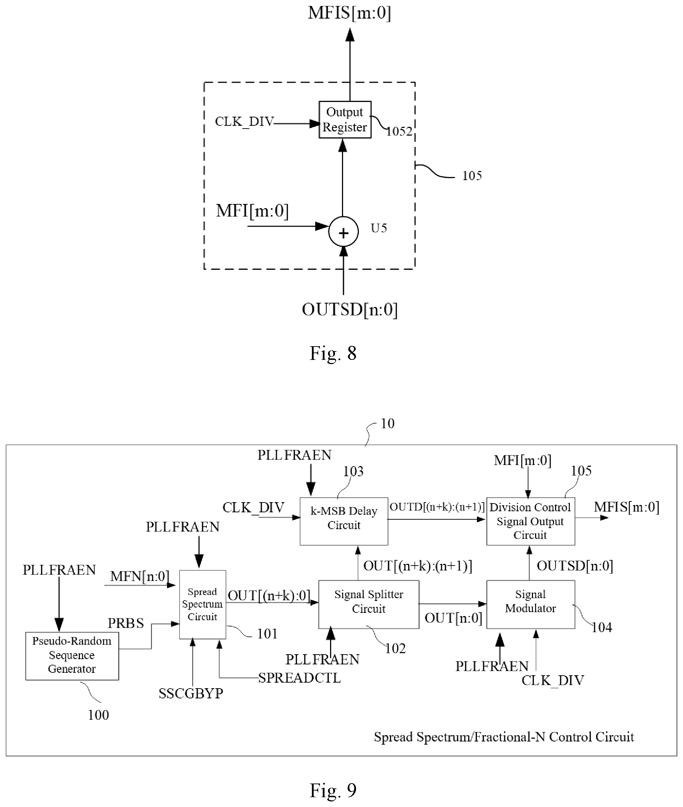

In one example, referring to Fig. 8, the frequency division control signal output circuit 105 includes a fourth accumulator U5 and an output register 1052. A first input of the fourth accumulator U5 is coupled to an output of the signal modulator 104, and a second input of the fourth accumulator U5 is coupled to the integer-N control signal MFI[m:0]. The fourth accumulator U5 is configured to superimpose the output OUTSD[n:0] of the signal modulator 104 and the integer-N control signal MFI[m:0]. An input of the output register 1052 is coupled to an output of the fourth accumulator U5. The output register 1052 is also coupled to the feedback clock signal CLK_DIV and is configured to temporally synchronize the output of the fourth accumulator U5 to the feedback clock signal CLK_DIV so as to output the second frequency division control signal MFIS[m:0] superimposed with integer-N division control signal.

In the above implementations, n, k and m may each be any appropriate value. Referring to Figs. 1 to 8, in one example, n=13, k=2 and m=7. Operation of the spread spectrum fractional-N control circuit 10 in this example is as described below.

At first, the triangular wave generator 1011 in the spread spectrum circuit 101 generates an initially-zero signal value, with the feedback clock signal CLK_DIV being taken as a reference clock signal, in a spread spectrum mode with fractional-N division (e.g., PLLFRAEN=1 and SSCGBYP=0), the signal is incremented by MODSTE upon the arrival of a rising edge in each subsequent cycle of CLK_DIV until a maximum value equal to MODSTEP*MODCNT is reached when the number of increments reaches MODCNT. After that, the signal is decremented by MODSTEP upon the arrival of a rising edge in each subsequent cycle of CLK_DIV until it drops back to 0, thereby obtaining the triangular wave signal TEMP [13:0]. At the same time, the first accumulator U1 in the spread spectrum circuit 101 superimposes MFN[13:0] on a pseudo-random sequence PRBS from the pseudo-random sequence generator 100.

Next, the second accumulator U2 in the spread spectrum circuit 101 superimposes the triangular wave signal TEMP and the MFN[13:0] that is combined with the pseudo-random sequence PRBS, generating a first superimposition, which is a triangular wave signal taking the feedback clock signal CLK_DIV as a reference clock signal. In the spread spectrum mode with fractional-N division (e.g., PLLFRAEN=1 and SSCGBYP=0), the signal is incremented by MODSTE upon the arrival of a rising edge in each cycle of CLK_DIV until it reaches a maximum value equal to MFN[13:0]+MODSTEP*MODCNT when the number of increments reaches MODCNT. After that, it is decremented by MODSTEP upon the arrival of a rising edge in each subsequent cycle of CLK_DIV until it drops back to MFN[13:0].

The subtractor U3 in the spread spectrum circuit 101 then subtracts a first subtrahend stored in the second register 1013. In the case of a center-spread spectrum mode, the first subtrahend stored in the second register 1013 is equal to 1/2*MODCNT*MODSTEP. In the case of a down-spread spectrum mode, the first subtrahend stored in the second register 1013 is equal to MODSTEP*MODCNT.

Subsequently, a 13-bit first frequency division control signal OUT[13:0] is output from the spread spectrum circuit 101 and modulated and shaped in the signal modulator 104, producing OUTSD[13:0]. In this way, quantization noise is spread to a higher frequency band, enabling the low-pass filter in the fractional-N PLL to filter out higher-frequency noise.

Afterwards, the frequency division control signal output circuit 105 sums the output OUTSD[13:0] of the signal modulator 104 and an integer-N control signal MFI[7:0], and the sum is then subjected to synchronization by clock in the output register 1052, producing a second frequency division control signal MFIS[7:0], which is then provided to the fractional-N divider 16 in the fractional-N PLL. The fractional-N divider 16 performs fractional division on the frequency of a clock signal from the VCO 15 based on MFIS[7:0], obtaining a new feedback clock signal CLK_DIV. Thus, the frequency of CLK_DIV can be eventually tuned to the reference frequency F_{ref} provided by the prescaler 11, achieving locking of the fractional-N PLL.

As discussed above, in this embodiment, there are provided a spread spectrum fractional-N control circuit including a spread spectrum circuit and a fractional-N PLL incorporating the spread spectrum fractional-N control circuit. In a spread spectrum mode, the spread spectrum circuit can superimpose an (n+1)-bit fractional-N control signal and an associated triangular wave signal and process the resulting superimposition in a manner associated with the spread spectrum mode, obtaining a first frequency division control signal. The spread spectrum circuit may process the superimposition in different ways in different non-spread and spread spectrum modes. After being modulated and shaped in a signal modulator, the first frequency division control signal is output as a second frequency division control signal from a frequency division control signal output circuit. A fractional-N divider then divides the frequency of a clock signal based on the second frequency division control signal. With this arrangement, non-spread and various spread spectrum modes (including many center- and down-spread spectrum modes) are supported, while effectively avoiding the issue of upward or downward distortion that occurs when the fractional-N ratio approaches 0 or 1 due to an excessive spread spectrum modulation amplitude. Additionally, a noise shaping technique can be adopted to effectively reduce spurs, enabling the fractional-N PLL to provide very good phase noise performance at a high frequency and resolution. Further, a step size MODSTEP and count MODCNT for spread spectrum modulation can be stored in registers, and can be calculated and reconfigured according to a spread spectrum modulation frequency and amplitude, if required, resulting in higher configuration flexibility and a wider range of application.

Further, in one example of this embodiment, referring to Fig. 2, the enable signal PLLFRAEN may be provided to the pseudo-random sequence generator 100, the spread spectrum circuit 101 and the signal modulator 104 in the spread spectrum fractional-N control circuit 10 to enable these circuits. In this way, the entire fractional-N and spread spectrum link in the spread spectrum fractional-N control circuit 10 can be deactivated by setting PLLFRAEN=0, reducing power consumption of the circuit in an integer-N-only mode.

In other examples of this embodiment, as long as the spread spectrum fractional-N control circuit is able to operate in a desired mode under the control of PLLFRAEN, SSCGBYP, SPREADCTL, MFN[n:0] and MFI[m:0], PLLFRAEN may not be input to part of the fractional-N and spread spectrum link in the spread spectrum fractional-N control circuit 10. For example, it may not be provided to at least one of the pseudo-random sequence generator 100 and the spread spectrum circuit 101. In these cases, when PLLFRAEN=0, only part of the fractional-N and spread spectrum link in the spread spectrum fractional-N control circuit 10 (including the signal modulator 104) will be deactivated.

Based on the same concept, this embodiment also provides a chip including the fractional-N PLL as discussed above and an internal circuit. A clock input of the internal circuit is coupled to the output of the VCO in the fractional-N PLL. The fractional-N PLL provides the internal circuit with a clock signal with reduced spurs.

Through incorporating the fractional-N PLL of the present application, the chip is effectively shielded from external EMI.

### Embodiment 2

As would be understood from Figs. 1 to 9, in the foregoing embodiment, the output OUTSD[n:0] of the signal modulator 104, which has undergone noise shaping, is summed with the integer-N control signal MFI[m:0]. The precision of the fractional-N division is (n+1) bits, and each accumulator M1 to M3 in the signal modulator 104 has a precision of (n+1) bits. When the fractional-N PLL operates in a fractional-N mode without a spread spectrum function (e.g., PLLFRAEN=1 and SSCGBYP=1), its frequency division ratio is an integer plus a fraction and may be denoted as "DIVN-DIVN+1". Therefore, if all bits of MFN[n:0] are full, the integer-N division ratio of the fractional-N PLL will be incremented by one. When the fractional-N PLL operates in a spread spectrum mode with fractional-N division (e.g., PLLFRAEN=1 and SSCGBYP=0), the maximum center- or down-spread spectrum modulation amplitude (=MODSTEP*MODCNT) is up to (n+1) bits. In the extreme cases, accumulator overflow (M1 or the like) in the signal modulator 104 may occur.

In view of the problem of possible accumulator overflow in the signal modulator 104, in this embodiment, there are provided a spread spectrum fractional-N control circuit 10 and a fractional-N PLL incorporating the spread spectrum fractional-N control circuit 10. The spread spectrum fractional-N control circuit 10 of this embodiment differs from that of the first embodiment in that the spread spectrum circuit 101 is further configured to extend the processed first superimposition by k bits in current spread spectrum mode, thereby outputting an (n+k+1)-bit first frequency division control signal OUT[(n+k):0]. In addition, the spread spectrum fractional-N control circuit 10 separates out k most significant bits (MSBs) OUT[(n+k):(n+1)] from OUT[(n+k):0]. This portion does not participate in the modulation and shaping within the signal modulator 104. Instead, after undergoing a corresponding delay, it is summed with OUTSD[n:0](OUT[(n+k):0] after being processed by the signal modulator 104), thereby obtaining a second frequency division control signal. Both n and k are integers and satisfy n≥0 and k≥2, respectively.

Referring to Fig. 1, the fractional-N PLL of this embodiment is of substantially the same architecture as that of the first embodiment. Specifically, it includes a prescaler (DIVM, also referred to as a "front-end divider") 11, a phase-frequency detector (PFD) 12, a charge pump (CHP) 13, a low-pass filter (LPF, also referred to as "loop filter") 14 and a voltage-controlled oscillator (VCO) 15, which are connected in sequence. It also includes a fractional-N divider (DIVN) 16 and the spread spectrum fractional-N control circuit 10. A first input of the fractional-N divider (DIVN) 16 is coupled to an output of the VCO 15, and a second input thereof is coupled to an output of the spread spectrum fractional-N control circuit 10. The modules in the fractional-N PLL are connected and function in the same way as those in the first embodiment, and further description in this regard is therefore omitted.

According to this embodiment, the spread spectrum fractional-N control circuit 10 performs spread-spectrum processing on a feedback clock signal CLK_DIV from the fractional-N divider. Such a combination of fractional-N and spread spectrum functions can dynamically modify a frequency division ratio of the fractional-N divider 16 so that an average frequency division ratio of the fractional-N divider 16 is maintained at a preset fractional value. Further, any conflicts between the frequency division ratios in fractional-N mode and spread spectrum mode and accumulator overflow in the signal modulator can be avoided, effectively suppressing EMI from the fractional-N PLL.

Referring to Fig. 9, in one example of this embodiment, the spread spectrum fractional-N control circuit 10 includes a pseudo-random sequence generator 100, a spread spectrum circuit 101, a signal splitter circuit 102, a k-MSB delay circuit 103, a signal modulator 104 and a frequency division control signal output circuit 105. In other examples, if required, the pseudo-random sequence generator 100 may be omitted from the spread spectrum fractional-N control circuit 10.

The pseudo-random sequence generator 100 is configured to generate and output a pseudo-random sequence PRBS. The spread spectrum circuit 101 is coupled to an (n+1)-bit fractional-N control signal MFN[n:0] and the pseudo-random sequence generator 100, and is configured to superimpose the (n+1)-bit fractional-N control signal MFN[n:0] and a triangular wave signal TEMP in a spread spectrum mode, obtaining a second superimposition. It is also configured to extend the second superimposition by k bits, thus obtaining an (n+k+1)-bit first frequency division control signal OUT[(n+k):0], where n and k are both integers and satisfy n≥0 and k≥2, respectively.

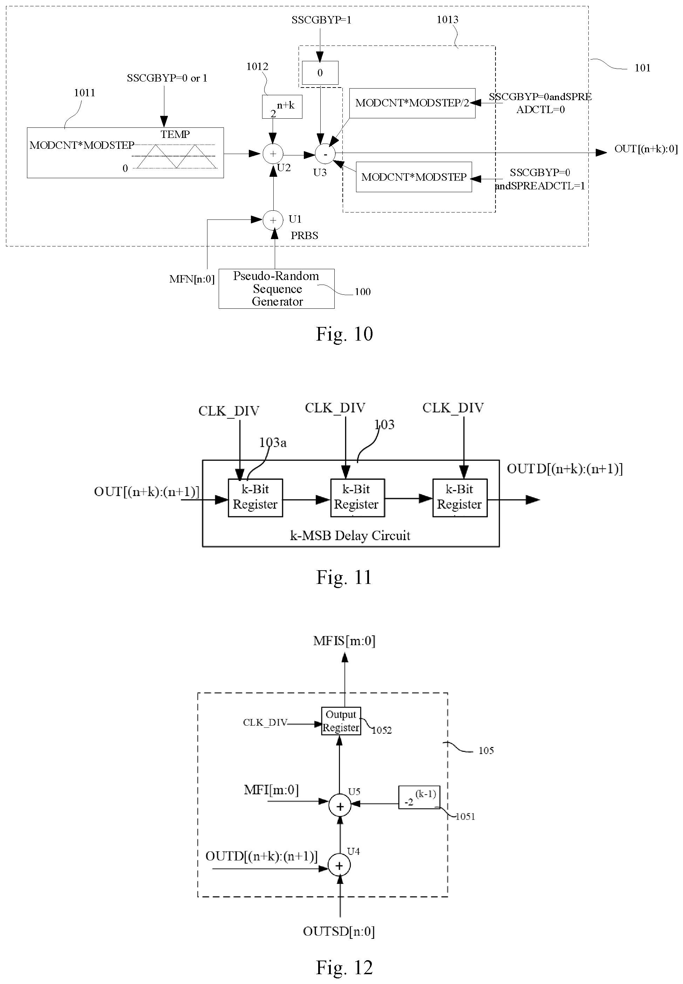

Optionally, referring to Fig. 10, the spread spectrum circuit 101 may include a first accumulator U1, a triangular wave generator 1011, a first register 1012, a second accumulator U2, a second register 1013 and a subtractor U3.

A first input of the first accumulator U1 is coupled to the (n+1)-bit fractional-N control signal MFN[n:0], and a second input thereof is coupled to the pseudo-random sequence generator 100. The first accumulator U1 is configured to superimpose the (n+1)-bit fractional-N control signal MFN[n:0] and a pseudo-random sequence PRBS output from the pseudo-random sequence generator 100, obtaining a second superimposition. It is also configured to feed the second superimposition to an input of the second accumulator U2.

The triangular wave generator 1011 is coupled to a spread spectrum mode control signal SSCGBYP and configured to generate and output a triangular wave signal TEMP corresponding to the (n+1)-bit fractional-N control signal MFN[n:0] in a spread spectrum mode (e.g., PLLFRAEN=1 and SSCGBYP=0). Alternatively, in a non-spread spectrum mode (e.g., PLLFRAEN=1 and SSCGBYP=1), it outputs 0. The triangular wave generator 1011 may generate the triangular wave signal TEMP in the spread spectrum mode (e.g., PLLFRAEN=1 and SSCGBYP=0) in the same way as described in the first embodiment, and further description in this regard is therefore omitted. The triangular wave signal TEMP is initially zero and takes the feedback clock signal CLK_DIV as a reference clock signal. TEMP is incremented by one step MODSTEP upon the arrival of a rising edge of the feedback clock signal CLK_DIV in each clock cycle until the number of increments MODCNT when TEMP is maximized at MODSTEP*MODCNT. From this point onwards, TEMP is decremented by one step MODSTEP upon the arrival of a rising edge in each clock cycle of the feedback clock signal CLK_DIV until it drops back to 0. MODCNT is configured by a register and calculated according to a modulation frequency f_{MOD} for the current spread spectrum mode and the frequency F_{ref} of a reference clock signal. MODSTEP is also configured by a register and calculated according to a modulation depth MD for the current spread spectrum mode, the (n+1)-bit fractional-N control signal MFN[n:0] and a (m+1)-bit integer-N control signal MFI[m:0]. MODCNT and MODSTEP may be calculated in the same manner as described in the first embodiment, and further description in this regard is therefore omitted.

The first register 1012 is configured to store an (n+k+1)-bit additional value, which is equal to 2^{n+k}, for example. A first input of the second accumulator U2 is coupled to an output of the triangular wave generator 1011, and a second input thereof is coupled to an output of the first accumulator U1 (i.e., to the (n+1)-bit fractional-N control signal MFN[n:0]). A third input of the second accumulator U2 is coupled to an output of the first register 1012. The second accumulator U2 is configured to superimpose the output from the triangular wave generator 1011, the additional value stored in the first register 1012 and the output of the first accumulator U1 (i.e., the superimposition of the pseudo-random sequence PRBS and the (n+1)-bit fractional-N control signal MFN[n:0]), thereby extending the signal by k bits. Here, the first register 1012 functions to extend the first superimposition of MFN[n:0] and TEMP (i.e., the sum of the fractional-N division and spread spectrum signals) by k bits and thereby prevent data overflow.

A first input of the subtractor U3 is coupled to an output of the second accumulator U2, and a second input thereof is coupled to the second register 1013. Optionally consisting of a bank of registers, the second register 1013 is coupled to the spread spectrum mode control signal SSCGBYP and a spread spectrum direction control signal SPREADCTL and used to configure a first subtrahend for the current mode (i.e., non-, center- or down-spread spectrum). The subtractor U3 is configured to subtract the first subtrahend that is stored in the second register 1013 from the output of the second accumulator U2, thereby producing an (n+k+1)-bit first frequency division control signal OUT[(n+k):0]. In a non-spread spectrum mode (e.g., PLLFRAEN=0 or 1, and SSCGBYP=1), the first subtrahend configured by the second register 1013 may be set to 0. In a center-spread spectrum mode (e.g., PLLFRAEN=1, SSCGBYP=0 and SPREADCTL=0), the first subtrahend in the second register 1013 may be set to MODSTEP*MODCNT/2. In a down-spread spectrum mode (e.g., PLLFRAEN=1, SSCGBYP=0 and SPREADCTL=1), the first subtrahend may be set to MODSTEP*MODCNT. Here, MODCNT represents a spread spectrum modulation step count stored in a register, and MODSTEP represents a spread spectrum modulation step size stored in a register.

As noted above, in this embodiment, the spread spectrum circuit 101 extends the first superimposition (resulting from superimposing the second superimposition and a triangular wave signal) by k bits, and the subtractor U3 then processes the resulting signal in a manner corresponding to the current mode (i.e., subtracting a corresponding first subtrahend). Therefore, compared with the first embodiment, the spread spectrum circuit 101 can additionally extend the processed version of the first superimposition by k bits. In alternative embodiments of the present invention, the subtractor U3 and the second register 1013 may be arranged upstream of the first register 1012, and an appropriate accumulator may be added to the first register 1012. With this arrangement, the first superimposition from the second accumulator U2 may be subtracted by an appropriate first subtrahend (i.e., processed in a manner corresponding to the current mode), and the processed version may be then extended by k bits.

Further, the aforementioned control signals, including the spread spectrum mode control signal SSCGBYP, the spread spectrum direction control signal SPREADCTL and the (n+1)-bit fractional-N control signal MFN[n:0] that the spread spectrum circuit 101 is coupled to and the integer-N control signal MFI[m:0], may be each configured by a respective register. The (n+1)-bit fractional-N control signal MFN[n:0] may be provided by an (n+1)-bit fractional-N configuration register.

In this embodiment, depending on different configurations of the enable signal PLLFRAEN, the spread spectrum mode control signal SSCGBYP, the spread spectrum direction control signal SPREADCTL, the (n+1)-bit fractional-N control signal MFN[n:0] and the integer-N control signal MFI[m:0], the spread spectrum fractional-N control circuit 10 may operate in one of a variety of modes, including integer-N-only, spread spectrum (center- or down-spread spectrum) with integer-N division, fractional-N division without spread spectrum, and spread spectrum (center- or down-spread spectrum) with fractional-N division. The values of PLLFRAEN, SSCGBYP, SPREADCTL, MFN[n:0] and MFI[m:0] may be the same as described in the first embodiment, and further description thereof is omitted herein.

With continued reference to Fig. 9, an input of the signal splitter circuit 102 is coupled to an output of the spread spectrum circuit 101 (i.e., an output of the subtractor U3), and the signal splitter circuit 102 is configured to cache or buffer the (n+k+1)-bit first frequency division control signal OUT[(n+k):0] from the spread spectrum circuit 101 and split the (n+k+1)-bit first frequency division control signal OUT[(n+k):0] into k most significant bits (MSBs) and (n+1) least significant bits (LSBs), obtaining a k-MSB signal OUT[(n+k):(n+1)] and an (n+1)-LSB signal OUT[n:0]. The signal splitter circuit 102 may be of any suitable circuit design, such as a signal decoder or a circuit capable of division and modulo operations, and the present invention is not limited to any particular circuit design.

Referring to Fig. 9, an input of the k-MSB delay circuit 103 is coupled to one output of the signal splitter circuit 102, and the k-MSB delay circuit 103 is configured to delay the k-MSB signal OUT[(n+k):(n+1)] from the signal splitter circuit 102. The k-MSB delay circuit 103 may be of any suitable circuit design. Optionally, referring to Fig. 11, the k-MSB delay circuit 103 may include a delay chain including a cascade of at least two first delay units 103a. The stage count of first delay units 103a may match a modulation duration of the signal modulator 104. In one example, the first delay units 103a may be a k-bit register to buffer, delay and output the k-MSB signal OUT[(n+k):(n+1)] from the signal splitter circuit 102.

With continued reference to Fig. 9, an input of the signal modulator 104 is coupled to another output of the signal splitter circuit 102, and the signal modulator 104 is configured to modulate and shape the (n+1)-LSB signal OUT[n:0] from the signal splitter circuit 102.

The k-MSB delay circuit 103 may delay the k-MSB signal OUT[(n+k):(n+1)] by an amount of time matching a time required by the signal modulator 104 to modulate and shape the (n+1)-LSB signal OUT[n:0] so that the delayed k-MSB signal OUTD[(n+k):(n+1)] from the k-MSB delay circuit 103 is synchronized with the modulated (n+1)-LSB signal OUTD[n:0] from the signal modulator 104. The signal modulator 104 may be of any suitable circuit design.

In one example, referring to Figs. 11 and 6, the k-MSB delay circuit 103 includes three first delay units 103a, and the signal modulator 104 is a MASH third-order Σ-Δ modulator. Possible MASH configurations include, but are not limited to, MASH1-1, MASH2-1 and MASH1-1-1. The third-order MASH1-1-1 configuration may be the same as that of the first embodiment and, therefore, need not be described in further detail herein.

As can be seen from Fig. 6, the signal modulator 104 outputs OUTSD[n:0]=C2-C2D1+C1D1-C2D1+C2D2-C1D2+C0D2. When n=13, the output may comprise eight different values [-3, -2, -1, 0, 1, 2, 3, 4]. In this case, with combined reference to Fig. 9, when n=13 and k=2, a signal (not labeled) resulting from the summation of OUTD[(n+k):(n+1)] from the k-MSB delay circuit 103 and OUTSD[n:0] from the signal modulator 104 carried out in the frequency division control signal output circuit 105 may comprise eleven different values [-3, -2, -1, 0, 1, 2, 3, 4, 5, 6, 7].

With combined reference to Figs. 1 and 10, the frequency division control signal output circuit 105 is coupled to the k-MSB delay circuit 103, the signal modulator 104 and the fractional-N divider (DIVN) 16 in the fractional-N PLL. The frequency division control signal output circuit 105 is configured to superimpose the output OUTD[(n+k):(n+1)] from the k-MSB delay circuit 103, OUTSD[n:0] from the signal modulator 104 and an associated integer-N control signal MFI[m:0], producing a second frequency division control signal MFIS[m:0] superimposed with the integer-N control signal, which is fed to the fractional-N divider 16. The fractional-N divider 16 is configured to divide the frequency (Fvco) of a clock signal output from the VCO 15 based on MFIS[m:0] from the frequency division control signal output circuit 105.

In one example, referring to Fig. 12, the frequency division control signal output circuit 105 includes a third accumulator U4, a third register 1051, a fourth accumulator U5 and an output register 1052. A first input of the third accumulator U4 is coupled to an output of the signal modulator 104, and a second input thereof is coupled to an output of the k-MSB delay circuit 103. The third accumulator U4 may be implemented as the same as an accumulator U7 in the signal modulator 104, or as a separate accumulator. The third accumulator U4 is configured to superimpose OUTD[(n+k):(n+1)] from the k-MSB delay circuit 103 and OUTSD[n:0] from the signal modulator 104. An output of the third register 1051 is coupled to a first input of the fourth accumulator U5, and the third register 1051 is configured to store a k-bit second subtrahend, which is equal to 2^{k-1}, for example. A second input of the fourth accumulator U5 is coupled to an output of the third accumulator U4, and a third input of the fourth accumulator U5 is coupled to the integer-N control signal MFI[m:0]. The fourth accumulator U5 is configured to sum the output of the third accumulator U4 and the integer-N control signal MFI[m:0] and subtract the second subtrahend (e.g., 2^{k-1}) configured by the third register 1051 from the sum. An input of the output register 1052 is coupled to an output of the fourth accumulator U5, and the output register 1052 is also coupled to the feedback clock signal CLK_DIV and configured to temporally synchronize the output of the fourth accumulator U5 to the feedback clock signal CLK_DIV, so as to output the second frequency division control signal MFIS[m:0] superimposed with integer-N control signal.

In the above implementations, n, k and m may each be any appropriate value. Referring to Figs. 1 and 10 to 13, in one example, n=13, k=2 and m=7. Operation of the spread spectrum fractional-N control circuit 10 in this example is as described below.

First of all, the triangular wave generator 1011 in the spread spectrum circuit 101generates a signal, with the feedback clock signal CLK_DIV being taken as a reference clock signal, in a spread spectrum mode with fractional-N division (e.g., PLLFRAEN=1 and SSCGBYP=0), the signal is incremented by MODSTE upon the arrival of a rising edge in each cycle of CLK_DIV until it reaches a maximum value when the total number of increments reaches MODCNT. From this point, it is decremented by MODSTEP upon the arrival of a rising edge in each cycle of CLK_DIV until it drops back to the initial value (e.g., 0 or another value), thereby generating a triangular wave signal TEMP. At the same time, the first accumulator U1 in the spread spectrum circuit 101 superimposes MFN[13:0] on a pseudo-random sequence PRBS from the pseudo-random sequence generator 100.

Next, the second accumulator U2 in the spread spectrum circuit 101 superimposes the triangular wave signal TEMP and the MFN[13:0] that is superimposed with the pseudo-random sequence PRBS, sums the resulting superimposition with an additional value 2¹⁵ from the first register 1012, and subtracts a first subtrahend from the second register 1013. In the case of a center-spread spectrum mode (e.g., PLLFRAEN=1, SSCGBYP=0 and SPREADCTL=0), the first subtrahend from the second register 1013 is 1/2*MODCNT*MODSTEP. In the case of a down-spread spectrum mode (e.g., PLLFRAEN=1, SSCGBYP=0 and SPREADCTL=1), the first subtrahend from the second register 1013 is MODSTEP*MODCNT. In the case of a non-spread spectrum mode (e.g., PLLFRAEN=1 and SSCGBYP=1), the first subtrahend from the second register 1013 is 0, and the triangular wave generator provides TEMP=0.

Subsequently, the signal splitter circuit 102 transmits a 2-bit MSB signal OUT[15:14] from the spread spectrum circuit 101 to the 2-MSB delay circuit 103, which then delays it by two cycles and outputs as OUTD[15:14]. On the other hand, a 13-LSB signal OUT[13:0] from the spread spectrum circuit 101 is modulated and shaped in the signal modulator 104 and output as OUTSD[13:0]. In this way, quantization noise is spread to a higher frequency band, enabling a low-pass filter in the fractional-N PLL to filter out higher-frequency noise.

OUTD[15:14] from the 2-MSB delay circuit 103 and OUTSD[13:0] from the signal modulator 104 are then summed in the third accumulator U4 of the frequency division control signal output circuit 105. The sum may comprise eleven different values [-3, -2, -1, 0, 1, 2, 3, 4, 5, 6, 7].

Afterwards, the fourth accumulator U5 in the frequency division control signal output circuit 105 sums the output of the third accumulator U4 with the integer-N control signal MFI[7:0] and subtracts the second subtrahend from the third register 1051 (which is equal to 2). The result undergoes clock synchronization in the output register 1052, obtaining a second frequency division control signal MFIS[7:0], which is then fed to the fractional-N divider 16 in the fractional-N PLL. The fractional-N divider 16 divides the frequency of a clock signal from the VCO 15 based on MFIS[7:0], obtaining a new feedback clock signal CLK_DIV. Thus, the frequency of CLK_DIV can be eventually tuned to a reference frequency F_{ref} provided by a prescaler 11, achieving locking of the fractional-N PLL.

As discussed above, in this embodiment, the spread spectrum circuit 101 extends the sum of fractional-N division and spread spectrum signals (i.e., the superimposition of MFN[n:0] and TEMP, which is additionally superimposed with the first subtrahend 2^{n+k} from the first register 1012) by k bits. Moreover, the second subtrahend 2^{k-1} is subtracted from the integer-N division ratio in the frequency division control signal output circuit 105, and the signal splitter circuit 102 extracts the k-MSB signal OUT[(n+k):(n+1)] from the extended signal. These k MSBs are not subjected to modulation and shaping by the signal modulator 104, but is delayed by the k-MSB delay circuit 103 and then directly summed with the signal OUTD[n:0] from the signal modulator 104. With this arrangement, the spread spectrum fractional-N control circuit of this embodiment and the fractional-N PLL incorporating the spread spectrum fractional-N control circuit provide both spread spectrum and fractional-N division, while allowing a spread spectrum frequency and amplitude to be flexibly configured to avoid distortion at a fractional-N ratio close to 0 or 1 when spread spectrum modulation is conducted over a wide lower or higher range. Additionally, a noise shaping technique can be adopted to effectively reduce spurs, enabling the fractional-N PLL to provide very good phase noise performance at a high frequency and resolution. Further, accumulator overflow can be avoided, resulting in an even wider range of application.

Further, in one example of this embodiment, referring to Fig. 9, the enable signal PLLFRAEN may be provided to the pseudo-random sequence generator 100, the spread spectrum circuit 101, the signal splitter circuit 102, the k-MSB delay circuit 103 and the signal modulator 104 in the spread spectrum fractional-N control circuit 10 to enable these circuits. In this way, the entire fractional-N and spread spectrum link in the spread spectrum fractional-N control circuit 10 can be deactivated by setting PLLFRAEN=0, reducing power consumption of the circuit in an integer-N-only mode.

In other examples of this embodiment, as long as the spread spectrum fractional-N control circuit is able to operate in a desired mode under the control of PLLFRAEN, SSCGBYP, SPREADCTL, MFN[n:0] and MFI[m:0], PLLFRAEN may not be input to part of the fractional-N and spread spectrum link in the spread spectrum fractional-N control circuit 10. In these cases, when PLLFRAEN=0, only part of the fractional-N and spread spectrum link that is coupled to PLLFRAEN is deactivated. This part may include at least one of some circuits in the pseudo-random sequence generator 100, the signal splitter circuit 102, the k-MSB delay circuit 103 and the spread spectrum circuit 101 and some circuits in the signal modulator 104.

Based on the same concept, embodiments of the present invention also provide a chip including the fractional-N PLL of the present application and an internal circuit. A clock input of the internal circuit is coupled to the output of the VCO in the fractional-N PLL. The fractional-N PLL provides the internal circuit with a clock signal with reduced spurs. Through incorporating the fractional-N PLL of the present application, the chip is effectively shielded from external EMI.

The description presented above is merely that of some preferred embodiments of the present invention and does not limit the scope thereof in any sense. Any and all changes and modifications made by those of ordinary skill in the art based on the above teachings fall within the scope as defined in the appended claims.

## Claims

1. A spread spectrum fractional-N control circuit (10), comprising:
a spread spectrum circuit (101) configured to superimpose an (n+1)-bit fractional-N control signal and a corresponding triangular wave signal (TEMP) in a corresponding spread spectrum mode, thereby obtaining a first superimposition, wherein a corresponding processing of the first superimposition is performed based on the spread spectrum mode to obtain a corresponding first frequency division control signal, and wherein the processing of the first superimposition is different from each other in a non-spread spectrum mode and different spread spectrum modes;
a signal modulator (104) coupled to the spread spectrum circuit (101) and configured to modulate and shape the first frequency division control signal; and
a frequency division control signal output circuit (105) coupled to the signal modulator (104) and a corresponding fractional-N divider (16), wherein the frequency division control signal output circuit (105) is configured to provide a second frequency division control signal to the fractional-N divider (16) according to an output from the signal modulator (104), wherein the fractional-N divider (16) is configured to divide a frequency of a corresponding clock signal based on the second frequency division control signal.

2. The spread spectrum fractional-N control circuit (10) of claim 1, wherein the first superimposition is initially equal to MFN[n:0], incremented by MODSTEP in each clock cycle of a feedback clock signal from the fractional-N divider (16) until a maximum value is obtained, and then the first superimposition is decremented by MODSTEP in each clock cycle of the feedback clock signal until MFN[n:0] is obtained, wherein the maximum value is MFN[n:0]+MODSTEP*MODCNT, where MFN[n:0] is the (n+1)-bit fractional-N control signal, MODSTEP is a spread spectrum modulation step size configured by a register, and MODCNT is a spread spectrum modulation step count configured by a register.

3. The spread spectrum fractional-N control circuit (10) of claim 2, wherein a value of MODCNT configured by the register is calculated according to a modulation frequency for the spread spectrum mode and a reference clock signal, and wherein a value of MODSTEP configured by the register is calculated according to a modulation depth for the spread spectrum mode, the (n+1)-bit fractional-N control signal and a corresponding integer-N control signal.

4. The spread spectrum fractional-N control circuit (10) of any one of claims 1 to 3, wherein the spread spectrum circuit (101) subtracts different first subtrahends from the first superimposition in the non-spread spectrum mode and the different spread spectrum modes, thereby achieving the different processing in the non-spread spectrum mode and the different spread spectrum modes, wherein the first subtrahend is configured by a second register (1013) or is calculated according to values of MODSTEP and MODCNT, where MODSTEP is a spread spectrum modulation step size configured by a register, and MODCNT is a spread spectrum modulation step count configured by a register.

5. The spread spectrum fractional-N control circuit (10) of claim 4, wherein the first subtrahend is equal to 0 in the non-spread spectrum mode, equal to MODSTEP*MODCNT/2 in a center-spread spectrum mode, or equal to MODSTEP*MODCNT in a down-spread spectrum mode; or
wherein the spread spectrum circuit (101) comprises:
a triangular wave generator (1011) configured to generate and output the triangular wave signal (TEMP) corresponding to the (n+1)-bit fractional-N control signal in the corresponding spread spectrum mode;
a second accumulator (U2) coupled to the triangular wave generator (1011) and the (n+1)-bit fractional-N control signal, wherein the second accumulator (U2) is configured to superimpose the output from the triangular wave generator (1011) and the (n+1)-bit fractional-N control signal and thereby output the first superimposition; and
a subtractor (U3) coupled to the second accumulator (U2) and configured to subtract the first subtrahend from the first superimposition output from the second accumulator (U2), thereby obtaining the first frequency division control signal.

6. The spread spectrum fractional-N control circuit (10) of any one of claims 1 to 3 and 5, wherein the spread spectrum circuit (101) is further configured to extend a result of the processing by k bits and thereby output an (n+k+1)-bit first frequency division control signal, where n and k are both integers and satisfy n≥0 and k≥2, respectively.

7. The spread spectrum fractional-N control circuit (10) of claim 6, wherein n=13 and k=2; or wherein the spread spectrum circuit (101) further comprises a first register (1012) storing an (n+k+1)-bit additional value, wherein the spread spectrum circuit (101) is further configured to superimpose the first superimposition or the result of the processing and the additional value and thereby extend the result of the processing by k bits.

8. The spread spectrum fractional-N control circuit (10) of claim 6, further comprising:
a signal splitter circuit (102) coupled to the spread spectrum circuit (101) and configured to split k most significant bits (MSBs) of the (n+k+1)-bit first frequency division control signal from a remaining (n+1) least significant bits (LSBs) of the (n+k+1)-bit first frequency division control signal, thereby obtaining a k-MSB signal and an (n+1)-LSB signal; and
a k-MSB delay circuit (103) coupled to the signal splitter circuit (102) and the frequency division control signal output circuit (105), wherein the k-MSB delay circuit (103) is configured to delay and provide the k-MSB signal output from the signal splitter circuit (102) to the frequency division control signal output circuit (105),
wherein the signal modulator (104) is further configured to modulate and shape the (n+1)-LSB signal output from the signal splitter circuit (102), and wherein the output from the signal modulator (104) is synchronized with the output from the k-MSB delay circuit (103); and
wherein the frequency division control signal output circuit (105) is further configured to superimpose the output from the signal modulator (104) and the output from the k-MSB delay circuit (103).

9. The spread spectrum fractional-N control circuit (10) of claim 8, wherein the k-MSB delay circuit (103) comprises a delay chain comprising a cascade of at least two first delay units (103a), and wherein a stage count of first delay units (103a) matches a modulation duration of the signal modulator (104); optionally
wherein the first delay unit (103a) is a k-bit register, and/or wherein the stage count of the first delay units (103a) is three and the signal modulator (104) is a third-order multi-stage noise shaping (MASH) sigma-delta modulator (SDM).

10. The spread spectrum fractional-N control circuit (10) of claim 8, wherein the frequency division control signal output circuit (105) is further configured to superimpose the output from the k-MSB delay circuit (103), the output from the signal modulator (104) and a corresponding integer-N control signal and then to subtract a k-bit second subtrahend, thereby obtaining the second frequency division control signal superimposed with integer-N control signal; optionally
wherein the frequency division control signal output circuit (105) comprises:
a third accumulator (U4) coupled to the signal modulator (104) and the k-MSB delay circuit (103), wherein the third accumulator (U4) is configured to superimpose the output from the k-MSB delay circuit (103) and the output from the signal modulator (104);
a third register (1051) for configuring the second subtrahend;
a fourth accumulator (U5) coupled to the third accumulator (U4), the third register (1051) and the corresponding integer-N control signal, wherein the fourth accumulator (U5) is configured to sum an output from the third accumulator (U4) and the integer-N control signal and then to subtract the second subtrahend; and
an output register (1052) coupled to the fourth accumulator (U5) and configured to synchronize an output from the fourth accumulator (U5) with the feedback clock signal feedbacking from the fractional-N divider (16) and thereby to output the second frequency division control signal.

11. The spread spectrum fractional-N control circuit (10) of any one of claims 1 to 3, 5 and 7 to 10, further comprising a pseudo-random sequence generator (100) configured to generate and output a pseudo-random sequence, wherein the spread spectrum circuit (101) further comprises a first accumulator (U1) coupled to the (n+1)-bit fractional-N control signal and the pseudo-random sequence generator (100), wherein the first accumulator (U1) is configured to: superimpose the (n+1)-bit fractional-N control signal and the pseudo-random sequence to obtain a second superimposition; and superimpose the second superimposition and the triangular wave signal (TEMP), thereby obtaining the first superimposition.

12. The spread spectrum fractional-N control circuit (10) of any one of claims 1 to 3, 5 and 7 to 10, wherein the spread spectrum circuit (101) is further coupled to an enable signal, a spread spectrum mode control signal and a spread spectrum direction control signal, and provides following operation modes depending on the enable signal, the spread spectrum mode control signal and the spread spectrum direction control signal:
(1) an integer-N-only mode, in which the enable signal is at a first level;
(2) a fractional-N mode without spread spectrum, in which the enable signal is at a second level and the spread spectrum mode control signal is at the second level; and
(3) a spread spectrum mode, in which the enable signal is at the second level and the spread spectrum mode control signal is at the first level, and which is a center-spread spectrum mode if the spread spectrum direction control signal is at the first level or a down-spread spectrum mode if the spread spectrum direction control signal is at the second level.

13. The spread spectrum fractional-N control circuit (10) of claim 12, wherein depending on the (n+1)-bit fractional-N control signal MFN[n:0] and the spread spectrum direction control signal, the spread spectrum circuit (101) further distinguishes the different spread spectrum modes into following modes:
(3-1) a center-spread spectrum mode with integer-N division, in which the spread spectrum direction control signal is at the first level and MFN[n:0]=0;
(3-2) a down-spread spectrum mode with integer-N division, in which the spread spectrum direction control signal is at the second level and MFN[n:0]=0;
(3-3) a center-spread spectrum mode with fractional-N division, in which the spread spectrum direction control signal is at the first level and MFN[n:0] ≠0; and
(3-4) a down-spread spectrum mode with fractional-N division, in which the spread spectrum direction control signal is at the second level and MFN[n:0] ≠0.

14. A fractional-N phase-locked loop (PLL), comprising a prescaler (11), a phase-frequency detector (12), a charge pump (13), a low-pass filter (14) and a voltage-controlled oscillator (VCO) (15) which are connected in sequence, wherein the fractional-N PLL further comprises a fractional-N divider (16) and the spread spectrum fractional-N control circuit (10) of any one of claims 1 to 13, wherein an output of the fractional-N divider (16) is coupled to a feedback input of the phase-frequency detector (12), a first input of the fractional-N divider (16) is coupled to an output of the VCO (15), and a second input of the fractional-N divider (16) is coupled to an output of the spread spectrum fractional-N control circuit (10).

15. A chip comprising the fractional-N PLL of claim 14.
